Europäisches Patentamt

European Patent Office

Office européen des brevets

(11) Publication number: **0 059 447**
**B1**

(12) **EUROPEAN PATENT SPECIFICATION**

(45) Date of publication of patent specification: **15.05.85**

(21) Application number: **82101485.9**

(22) Date of filing: **26.02.82**

(51) Int. Cl.⁴: $H\ 03\ B\ 5/32$, $H\ 03\ H\ 9/05$

(54) **Piezoelectric oscillator device.**

(30) Priority: **28.02.81 JP 28752/81**
**21.07.81 JP 114870/81**
**08.08.81 JP 124512/81**
**29.12.81 JP 213923/81**

(43) Date of publication of application:
**08.09.82 Bulletin 82/36**

(45) Publication of the grant of the patent:
**15.05.85 Bulletin 85/20**

(84) Designated Contracting States:
**DE GB**

(56) References cited:
**EP-A-0 019 185**
**DE-A-2 701 200**
**DE-A-2 755 116**
**GB-A-2 063 558**
**US-A-3 359 435**
**Patent Abstracts of Japan Vol. 4, No. 109, 6 August 1980 page 32E20**
**Patent Abstracts of Japan Vol. 1, No. 72, 13 July 1977 page 830E77**

(73) Proprietor: **KINSEKI, LTD.**
**8-1, Izumihoncho 1-chome**
**Komae-shi Tokyo (JP)**

(72) Inventor: **Takeuchi, Masakazu**
**11-1, Kaminoge 3-chome**
**Setagaya-ku Tokyo (JP)**

(74) Representative: **Kehl, Günther, Dipl.-Phys. et al**
**Patentanwälte GEYER, HAGEMANN & KEHL**
**Ismaninger Strasse 108 Postfach 86 03 29**
**D-8000 München 86 (DE)**

## Description

This invention relates to a piezoelectric oscillator device of the type wherein exciting electrodes attached to the opposite surfaces of a piezoelectric oscillating plate are electrically and mechanically bonded to lead terminals and the piezoelectric oscillating plate is housed in a casing, whereby the piezoelectric oscillating plate is further provided with lead electrodes extending from the exciting electrodes to the periphery of the piezoelectric oscillating plate, an insulating base made of a thermoplastic resin being provided with a recess adapted to receive said piezoelectric oscillating plate, a pair of lead terminals being embedded in said insulating base, and an outer end of each lead terminal (201, 202) extending outside from the said insulating base, said lead electrodes being electrically and mechanically bonded to said pair of lead terminals in said recess, a lid made of thermoplastic resin being fitted in said recess, and the inside wall of the recess and the outside wall of the lid are fused together to form an airtight casing for the piezoelectric oscillator.

A piezoelectric oscillator device of this kind is known from JP—A—55—66115. In the known oscillator device leads are buried into a plastic case and the cover is placed over the oscillator element accommodated in the case. However the electrode and the lead of the oscillating plate are bonded together by a conductive bonding agent injected there between. The bonding is, therefore, unstable. The electric resistance is high. Moreover, the conductive bonding agent functions to bond the cover and the case, too, which degrades the dependability and the airtightness. Specifically, bonding agent, when hardened, becomes week against shock and cracks when shocked. For injecting the bonding agent the cover must be provided with a hole and requires a member to subsequently seal the hole.

Accordingly it is an object of this invention to provide a piezoelectric oscillator device having supports having a sufficiently high mechanical strength and which is not effected by a temperature of the substrate and can be assembled readily.

According to the invention this object is achieved in that a first one of said electrodes is bent about the periphery of the oscillating plate to form a contact surface on the same side of the oscillating plate on which the contact surface of the second electrode is disposed and that the lead terminals pass through the insulating base and having portions on the bottom of the recess to which portions the contact surfaces are bonded.

Brief Descriptions of the Drawings

In the accompanying drawings:
Fig. 1 is a front view of a quartz oscillating plate;
Fig. 2 is a sectional view taken along a line II—II shown in Fig. 1;
Fig. 3 is a front view of a lead terminal frame;
Fig. 4 is a front view showing an insulating substrate fixed to the lead terminal frame;
Fig. 5 is a sectional view taken along a line V—V shown in Fig. 4;
Fig. 6 is a front view showing the quartz oscillating plate mounted and electrically connected to a lead terminal;
Fig. 7 is a sectional view of the assembly shown in Fig. 6 taken along a line VII—VII;
Fig. 8 is a front view of a lid;
Fig. 9 is a sectional view of the lid shown in Fig. 8 taken along a line VIII—VIII;
Fig. 10 is a plan view showing the lid mounted on the shoulder of the insulating substrate;
Fig. 11 is a sectional view of the assembly shown in Fig. 10 taken along a line XI—XI;
Fig. 12 is a front view showing the lid fused to the projection of the insulating substrate;
Fig. 13 is a sectional view of the assembly shown in Fig. 12 taken along a line XIII—XIII;
Figs. 14 through Fig. 26 show a modified embodiment of this invention applied to a square quartz oscillator in which;

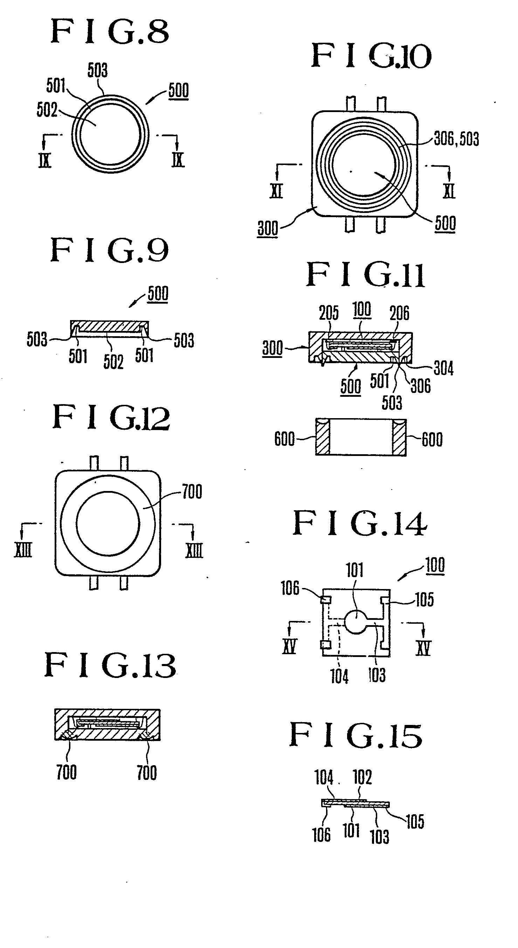

Fig. 14 is a front view of a crystal oscillating plate;
Fig. 15 shows a sectional view thereof taken along a line XV—XV shown in Fig. 14;

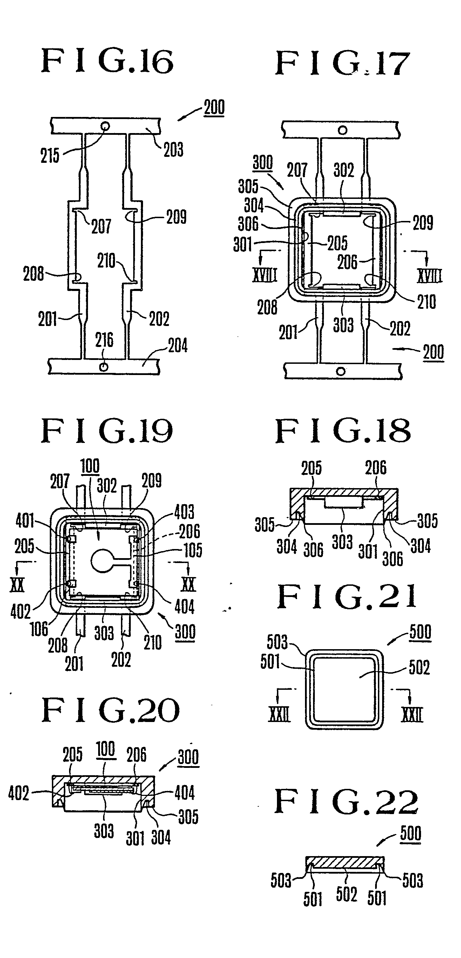

Fig. 16 is a front view of a lead terminal frame;
Fig. 17 is a front view showing an insulating substrate secured to the lead terminal frame;
Fig. 18 is a sectional view of the assembly shown in Fig. 17 taken along a line XVIII—XVIII;
Fig. 19 is a front view showing the quartz oscillating plate mounted on and electrically connected to a lead terminal;
Fig. 20 is a sectional view of the assembly shown in Fig. 19 and taken along a line XX—XX;
Fig. 21 is a front view of a lid;
Fig. 22 is a sectional view of the lid taken along a line XXII—XXII in Fig. 21;

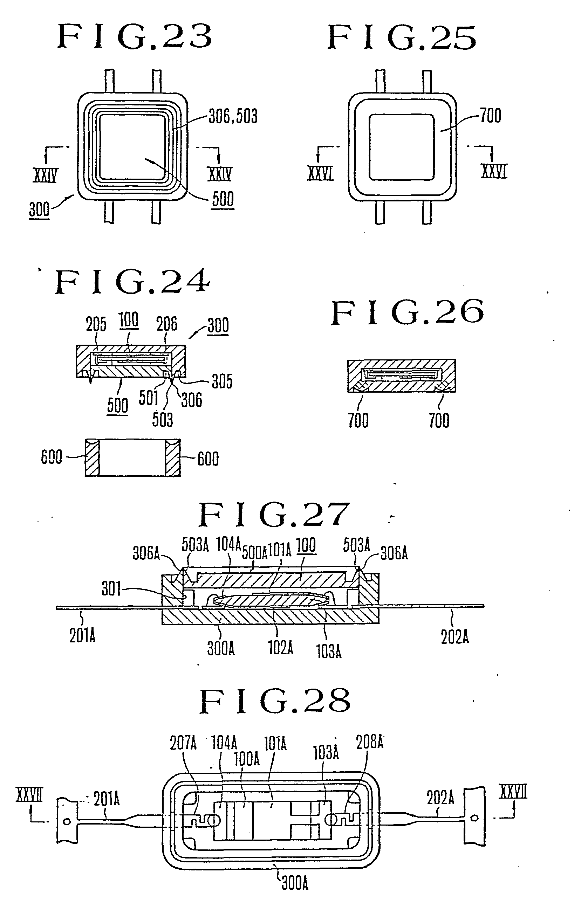

Fig. 23 is a front view showing the lid mounted on a shoulder of the insulating substrate;
Fig. 24 is a sectional view of the assembly shown in Fig. 23 and taken along a line XXIV—XXIV;
Fig. 25 is a front view showing the lid fused to a projection of the insulating substrate;
Fig. 26 is a sectional view of the assembly shown in Fig. 25 taken along a line XXVI—XXVI;
Fig. 27 is a sectional view showing a modification of the assembly;
Fig. 28 is a plan view of the assembly shown in Fig. 27 with a lid removed;

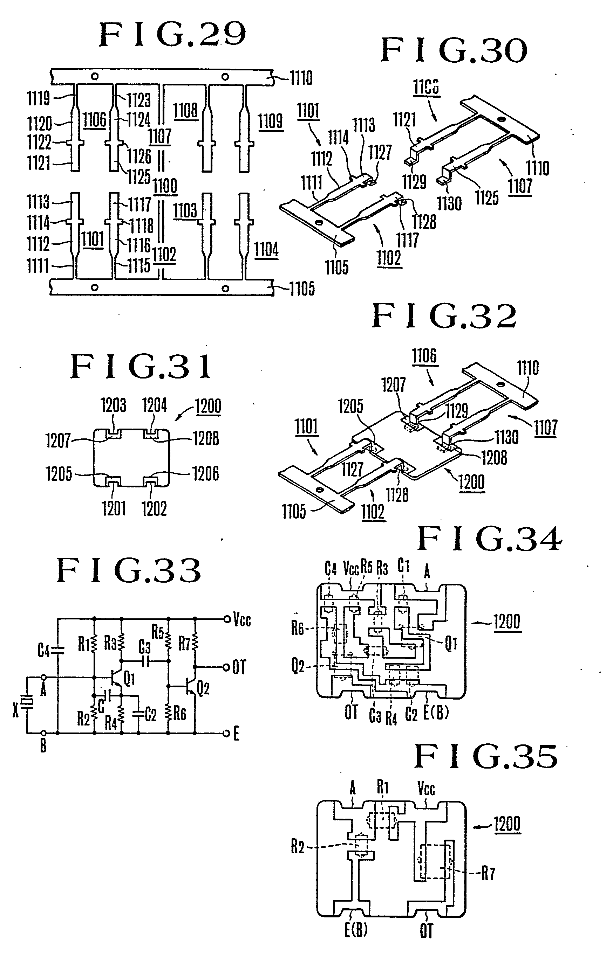

Fig. 29 is a plan view showing a modified lead terminal frame;
Fig. 30 is a perspective view of lead terminals with their inner ends bent into L shapes;
Fig. 31 is a plan view of a printed substrate;
Fig. 32 is a perspective view showing a state in which the printed substrate is mounted on the lead terminals;
Fig. 33 show a connection diagram of a quartz oscillator mounted on the printed substrate;
Fig. 34 is a rear view of the printed substrate mounted with principal circuit components of the oscillator;

Fig. 35 is a front view of the printed substrate shown in Fig. 33;

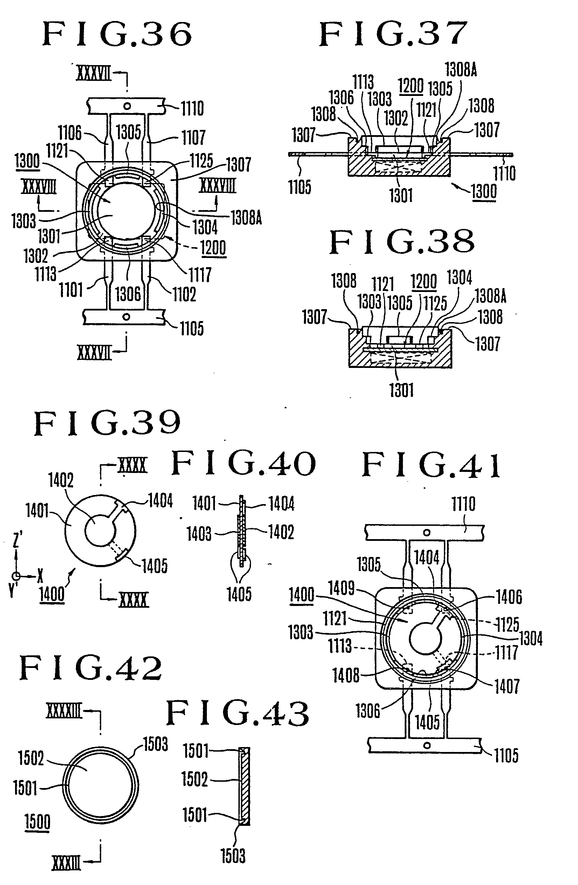

Fig. 36 is a plan view showing a state in which a printed substrate is embedded in an insulating base;

Fig. 37 is a sectional view of the assembly shown in Fig. 36 taken along a line XXXVII—XXXVII;

Fig. 38 is a sectional view of the same assembly taken along a line XXXVIII—XXXVIII;

Fig. 39 is a plan view of a quartz oscillating plate;

Fig. 40 is a sectional view thereof taken along a line XXXX—XXXX shown in Fig. 39;

Fig. 41 is a plan view showing a state in which the quartz oscillating plate is disposed in a recess of the insulating base;

Fig. 42 is a plan view of a lid;

Fig. 43 is a sectional view thereof;

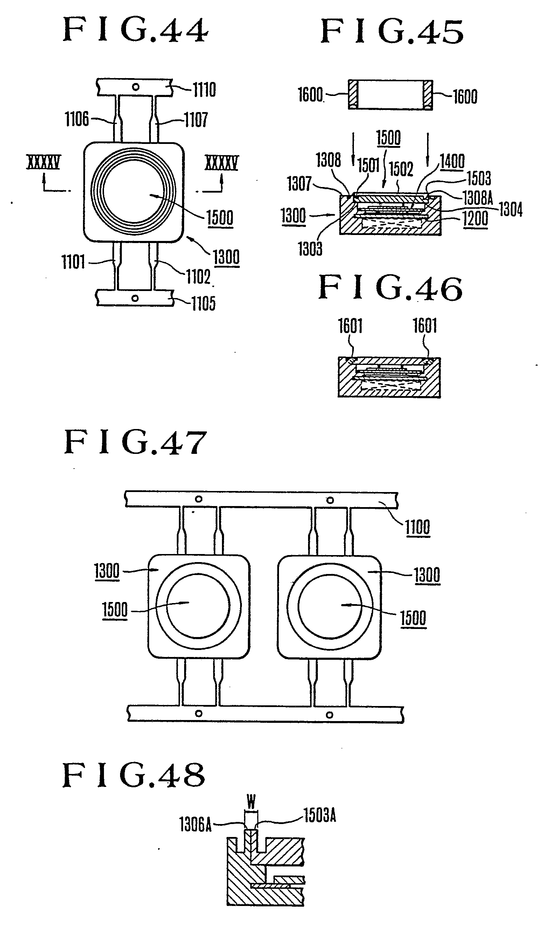

Fig. 44 is a plan view showing a state in which the lid is fitted in a recess of the insulating base;

Fig. 45 is a sectional view of the assembly shown in Fig. 44 taken along a line XXXXV—XXXXV;

Fig. 46 is a sectional view of the assembly shown in Fig. 44 after fusion; and

Fig. 47 is a plan view after assembling; and

Fig. 48 is a partial sectional view of the assembly.

Description of the Preferred Embodiments

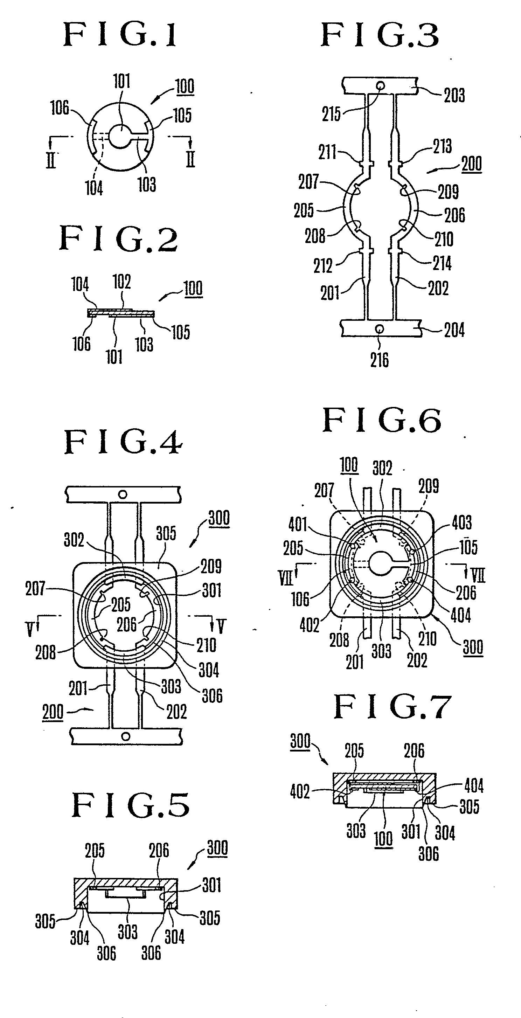

Figs. 1 through 13 show one embodiment of this invention in which the invention is applied to a circular quartz oscillator. As shown in Figs. 1 and 2 a quartz oscillating plate 100 comprises an AT cut circular quartz plate having a diameter of 6 mm. Near the centers of both main surfaces thereof are disposed opposing exciting electrodes 101 and 102 for exciting a thickness shear mode vibration in the quartz oscillating plate 100. Lead electrodes 103 and 104 extend from the exciting electrodes 101 and 102 in the opposite directions (at position not to oppose each other) toward the periphery of the quartz oscillating plate 100. The outer end portions 105 and 106 of the lead electrodes 103 and 104 are enlarged to have arcuate configurations extending along the periphery of the quartz oscillating plate 100. The rear side lead electrode 104 is bent to the front side 106 about the periphery of the quartz oscillating plate 100. The electrodes 101, 102, 103 and 104 are formed by vacuum vapor deposition of gold, silver, or aluminum by using a mask.

As shown in Fig. 3, a lead terminal frame 200 is integrally formed as by press work or etching and made of metal having substantially the same thermal expansion coefficient as that of an insulating substrate to be described later. In this example, a brass having a thermal expansion coefficient of 1.8 to 2.3 × 10⁻⁵/degree is used. The lead terminal frame 200 comprises a pair of lead terminals 201 and 202 with their opposite ends interconnected by common parallel holders 203 and 204 respectively. After completion of the piezoelectric oscillator the common parallel holders 203 and 204 are cut away.

The central portions 205 and 206 of the lead terminals 201 and 202 adapted to support the quartz oscillating plate 100 are arcuate and provided with centripetal notches 207, 208, 209 and 210 near the ends of the arcuate portions. The lead terminals 201 and 202 are also provided with stops 211, 212, 213 and 214 at positions at which the lead terminal penetrates through and secured to an insulating substrate or base 300 to be described later. Openings 215 and 216 provided for the common holders 203 and 204 are used to align the position of the lead terminal frame 200.

As shown in Figs. 4 and 5 the insulating substrate 300 is provided with a circular recess 301 in one surface thereof. The bottom of the recess 301 is used to support the arcuate portions 205 and 206 of the lead terminals 201 and 202, and the stops 211, 212, 213 and 214 of the lead terminals 201 and 202 are embedded in the insulating substrate 300 when molding the same. The insulating substrate 300 is made of a thermoplastic resin having sufficient bonding force, flexibility and compatibility to another resin. In this example a polycarbonate resin having a thermal expansion coefficient of 2 to 3 × 10⁻⁵/degree is used. Shoulders 302 and 303 adapted to support a lid 500 to be described later are formed in the recess 301 at portions beyond the notches 207, 208, 209 and 210 of the arcuate portions 205 and 206 of the lead terminals 201 and 202 so as to secure the lead terminals. A circular groove 304 is formed on an upper surface 305 of the substrate 300 adjacent to the side wall of the recess 301 to form a sharp projection 306.

As shown in Figs. 6 and 7, the quartz oscillating plate 100 is mounted on the arcuate portions 205 and 206 of the lead terminals 201 and 202 with the peripheral portions 105 and 106 of the lead electrodes 103 and 104 correctly positioned. Electroconductive bonding agents 401, 402, 403 and 404 such as DOTITE (trade name) sold by FUJIKURA KASEI CO., LTD. are applied to the opposite ends of the peripheral portions 105 and 106, and to the arcuate portions 205 and 206 of the lead terminals 201 and 202 adjacent the opposite ends for electrically and mechanically bonding the quartz oscillating plate 100 to the lead terminals 201 and 202 at four points. Since these bonded portions 401, 402, 403 and 404 are located between the notches 207, 208, 209 and 210 of the arcuate portions 205 and 206 of the lead terminals 201 and 202, these notches are located between the portions of the insulating substrate 300 at which the lead terminals 201 and 202 extend and secured to the substrate, and the bonding portions 401, 402, 403 and 404 of the quartz oscillating plate 100.

As shown in Figs. 8 and 9 the lid 500 has a circular configuration to fit in the inner wall of the recess 301 of the insulating substrate 300 and made of a polycarbonate resin like the insulating substrate 300. A circular groove 501 is formed on the periphery of the lid 500 to define a sharp projection 503 projecting beyond the upper surface of the lid 500.

As shown in Figs. 10 and 11, the lid 500 is mounted on the shoulders 302 and 303 in the recess 301 of the insulating substrate 300 to cause the outer side surface of the projection 503 of the lid 502 to engage the inner side surface of the projection 306 of the recess 301 and these engaging projections are heated to a temperature about 30 to 100 degrees higher than the melting point of the insulating substrate 300 and the lid 500 by applying annular heating pad 600 from above to fuse together both projections 306 and 503. In this example, the heating temperature is about 300 degrees in Centigrade. Since the projections 306 and 503 are sharply pointed, their sharp ends have a relatively small heat capacity so that they melt relatively readily. Once the sharp ends begin to melt, the melting propagates to the base portions of the projections, thus forming an annular melted portion 700 as shown in Figs. 12 and 13. The annular heating pad 600 is then removed and the melted portion 700 is allowed to cool to room temperature. To prevent sticking of the heating pad 600, the tip thereof may be coated with Teflon (tradename of Du Pont) resin or a Teflon resin sheet having heat resistant and non-sticky properties may be interposed between the heating pad 600 and the projections 503 and 306 at the time of fusing the projections.

Since a pair of the lead terminals is molded and embedded in the insulating substrate made of thermoplastic resin, component parts in assembling are reduced in number comparable to the prior art device. Further, embedding the lead terminals makes it easy to assembly the component parts. For example, after the embedded lead terminals are embedded in the insulating substrate, the piezoelectric oscillating plate having the exciting and lead electrodes is dropped in the recess of the insulating substrate and then the lid is inserted in the recess, and that the projections of the peripheral wall of the recess and the lid are fused together, thus completing the assembled oscillating device.

Therefore, the above mentioned steps for manufacturing the piezoelectric oscillator device is simpler than that for the prior art device. Further, it is understood that the above steps do not use special means for positioning or mounting component parts.

Since the notches are located between the positions at which the insulating substrate is secured and the bonding positions of the quartz oscillating plate as above described in connection with the first embodiment, even when the thermal expansion coefficient 2 to 3 × 10⁻⁵/degree of the polycarbonate resin is larger than that 0.7 to 1.3 × 10⁻⁵/degree of the quartz oscillating plate it is possible to absorb or alleviate the stress caused by the expansion and constriction due to the difference in the thermal expansion coefficients. That is to say, even when the quartz oscillating plate is securely fixed to the lead terminals, the adverse effect of the temperature characteristic of the supporting structure can be eliminated by the notches. As a consequence, peel off of the bonded portions can be prevented, thus permitting the quartz oscillator to manifest its inherent frequency-temperature characteristic. Moreover as the quartz oscillating plate can be mounted on the insulating substrate by merely disposing the same in the recess and by applying the electroconductive bonding agents to portions to be bonded, the assembling operation is extremly simple and can be automated. Moreover, since the insulating substrate and the lid are made of the same thermoplastic material as a polycarbonate and the projections of the substrate and the lid are fused together, the resulting casing has a sufficiently high air tightness. Thus, the resulting casing passed a so-called boiling water test. Other examples of the thermoplastic resins include ethylene-vinyl acetate copolymers (EVA), polyethylene attacktic polypropylene (APP), ethylene-ethyl acrylate copolymers (EEA), polyamides, polyesters, polyphenylene sulfides (PPS), polyphenylene oxides (PPO), polyethylene terephthalates (PBT), etc. Further, instead of slit shaped notches, semicircular, triangular, square or any other shaped notches may be used.

Figs. 14 through 26 show a modified embodiment of this invention in which the invention is applied to a square quartz oscillator. In Figs. 14 through 26, elements corresponding to those shown in Figs. 1 through 13 are designated by the same reference numerals.

In a modification shown in Figs. 27 and 28, a strip shaped or rectangular quartz oscillating plate 100A is used. In relation with the shape of the oscillating plate 100A an insulating substrate 300A with a rectangular recess 301 is provided. On the insulating substrate 300A, opposing exciting electrodes 101A and 102A are provided for exciting a thickness shear mode vibration in the quartz oscillating plate 100A. Lead electrodes 103A and 104A extend from the exciting electrodes 101A and 102A in the opposite directions toward the periphery of the quartz oscillating plate 100A. These lead electrodes 103A and 104A are connected to end portions of the lead terminals 201A and 202A. These lead terminals 201A, 202A includes S-shaped bridge portions 207A, 208A, formed in combination with two notches respectively, between the end portions and intermediate portions which are embedded in the insulating substrate 300A. The S-shaped bridge portions compensate the stress caused by the expansion and constriction of the oscillating plate 100A, the insulating substrates 300A and the lead terminals 201A and 202A. The shape of the projections 306A and 503A of the substrate 300A and the lid 500A is similar to that of the substrate 300 and the lid 500 shown in Figs. 1 to 13. Said lead terminals 201A, 202A are embedded and extend to the outside through the insulating substrate 300A. According to this example two lead conductors are aligned on a line spaced from each other at a central portion of the rectangular recess 301 for receiving the piezoelectric oscillator.

In a modified embodiment shown in Figs. 29 through 47, a lead terminal frame 1100 is integrally formed by press working or etching a single brass plate, the brass having substantially the same expansion coefficient as an insulating base. The opposite ends of four lead terminals 1101, 1102, 1103 and 1104 are interconnected by common parallel holders 1110 and 1105 respectively. Lead terminals 1101, 1102, 1106, 1107, 1103, 1104, and 1108, 1109 are respectively paired and number of pairs may be 30, for example. Since all lead terminals have the same shape, the construction of the lead terminal 1101 will be described in detail as an example. Similar to a known IC terminal the common holder 1105 and connector 1111 have a relatively small width, while terminal portions 1112, 1113, 1121 and 1120 have larger width. Different from previous first and second embodiments portions 1112, 1113 and 1121 and 1120 are not continuous and they are used to support a piezoelectric oscillator as will be described later. Lateral projections or stops 1114 and 1122 are provided between portion 1112 and 1113 and between 1121 and 1120 for securing the frame to an insulating base 1300.

The other lead terminal 1102 of the pair has narrow portions 1115, 1123, wide portions 1116, 1117, 1125, 1124 and lateral projections 1118 and 1126 as shown in Figs. 29 and 30, inner ends 1127, 1128, 1129 and 1130 of the intermediate portions 1113, 1117, 1121 and 1125 are bent downwardly into L shapes.

As shown in Fig. 31, a printed substrate 1200 is provided with recesses 1201, 1202, 1203 and 1204 at positions corresponding to L shaped inner ends 1127, 1128, 1129 and 1130, and metal films 1205, 1206, 1207 and 1208 formed by soldering or plating to surround respective recesses. As shown in Fig. 32, the printed substrate 1200 can be mounted on the L shaped inner ends 1127, 1128, 1129 and 1130 of the portions 1113, 1117, 1121 and 1125 of the lead terminals. Then the bent inner ends 1127 through 1130 of the lead terminals are soldered to the metal films 1205 through 1208. For the sake of simplicity although circuit components of the oscillator are not shown in Figs. 31 and 32, these circuit elements are shown in Fig. 33 in detail.

As shown in Fig. 33, the oscillating circuit comprises a quartz oscillator X, transistors Q1 and Q2, printed resistors R1 through R7, chip capacitors C1 through C4. Since such oscillating circuit is well known, it is considered it unnecessary to describe its operation. These circuit elements are mounted on the printed substrate 1200 as shown in Figs. 34 and 35, and then soldered to the printed substrate. Junctions A and B on the opposite sides of the quartz oscillator X and a grounding terminal E shown in Fig. 33 are connected to the metal films 1206 and 1208 respectively, while a source terminal Vcc and an output terminal OT are also connected to the metal films 1205 and 1207 respectively.

After connecting the printed substrate 1200 mounted with the oscillating circuit to the L shaped inner ends 1127 through 1130 of the lead terminals, the printed substrate 1200 is embedded in an insulating base 1300 when molding the same as shown in Figs. 36, 37 and 38. The insulating base 1300 is made of an insulating material having substantially the same thermal expansion coefficient as brass, for example a polycarbonate resin. The insulating base 1300 has a square shape and provided with a recess 1301 in one surface thereof. A predetermined number of shoulders 1302 through 1306 are formed in the recess 1301. The upper surface of the shoulder 1302 lies in the same plane as the terminal portions 1113, 1117, 1121 and 1125 for supporting a quartz oscillating plate 1400 (to be described later) together with the terminal portions described above. The shoulders 1303, 1304, 1305 and 1306 are used to support a lid 1500 to be described later. A circular groove 1308 is formed in the upper surface 1307 of the peripheral wall of the recess 1301 to form a sharply pointed projection 1308A.

The printed substrate 1200 mounted with circuit elements is embedded near the bottom portion of the insulating base 1300. Although the front surfaces of the terminal portions 1113, 1117, 1121 and 1125 are exposed the rear surfaces of the terminal portions are embedded in the shoulder 1302.

The terminal portions 1113, 1117, 1121, 1125 and projections 1114, 1118, 1122 and 1126 of the lead terminals extend toward outside from the inner side of the recess 1301 of the insulating base 1300 and then fixed. Where the lead terminals are integrally formed with the lead terminal frame, it is necessary to extend the lead terminals laterally through the insulating base. However where the inner ends of portions 1113, 1117, 1121 and 1125 are bent into L shapes or deformed into such shapes that makes it difficult to extend the lead terminals laterally, the outer ends of them are slantly projected from the bottom of the insulating base.

As shown in Figs. 39 and 40 the quartz oscillating plate 1400 comprises an AT cut quartz plate 1401, exciting electrodes 1402 and 1403 on the opposite surfaces thereof, and radial lead electrodes 1404 and 1405 which are provided at not overlapping positions. These electrodes 1402 through 1405 are prepared by vapor-depositing gold, silver or aluminum. As shown in Fig. 41, the quartz oscillating plate 1400 is disposed in the recess 1301 of the insulating base 1300 such that the lead electrodes 1404 and 1405 are mounted on the terminal portions 1125 and 1117. Then, electroconductive bonding agents 1406 and 1407 are applied for electrically and mechanically connecting the lead electrodes 1404 and 1405 to the terminal portions 1125 and 1117. Although other terminal portions 1113 and 1121 may not be electrically connected, in order to more rigidly connect them mechanically it is advantageous to apply electroconductive bonding agents 1408 and 1409.

As shown in Figs. 42 and 43 a lid 1500 adapted to cover the insulating base 1300 takes the form of a circle and is provided with a circular groove 1501 near its periphery for defining a sharply pointed projection 1503. Like the insulating base 1300, the lid 1500 is also made of a thermoplastic resin for example a polycarbonate resin or other oxynthetic resins or copolymers mentioned above.

As shown in Figs. 44 through 45, the lid 1500 is mounted on the shoulders in the recess 1301 of the insulating base 1300. Then the interfitting projections 1308A and 1503 of the recess 1301 and the lid 1500 are heated by a heating pad 1600 for fusing together the projections. By the fusion, the projections are deformed to have a configuration shown by 1601 as shown in Fig. 46.

Any desired number of the quartz oscillators 1500 may be mounted on the lead terminal frame 1100 as shown in Fig. 47.

With the construction described above it is possible to miniaturize the insulating base to have dimensions of 13 × 13 × 5 mm. Moreover, the piezoelectric oscillator of this invention can be easily fabricated so that it can be manufactured automatically.

As many apparently widely different embodiments of this invention may be made without departing from the scope thereof. For example, the sectional shape of the sharp projections 306 and 503 as shown in Figs. 5 and 9 may be changed to that of projections 1306A and 1503A, each having a uniform thickness of about 1 to 2 mm as shown in Fig. 48. In such a case, the total width, combining the thickness of the projection 1306A with the thickness of the projection 1503A, is preferably less than 3 mm.

Although in the foregoing embodiments a quartz oscillating plate was used other piezoelectric substance can also be used, for example, lithium tantalate, lithium neobate and piezoelectric ceramic.

Further, although in the foregoing embodiments the lead terminals are made of metal, they may be substituted by conductive member including conductive materials or having a conductive characteristic.

**Claims**

1. A piezoelectric oscillator device of the type wherein exciting electrodes (101, 102) attached to the opposite surfaces of a piezoelectric oscillating plate (100) are electrically and mechanically bonded to lead terminals (201, 202) and the piezoelectric oscillating plate (100) is housed in a casing, whereby the piezoelectric oscillating plate (100) is further provided with lead electrodes (103, 104) extending from the exciting electrodes (101, 102) to the periphery of the piezoelectric oscillating plate (100), an insulating base (300) made of a thermoplastic resin being provided with a recess (301) adapted to receive said piezoelectric oscillating plate (100), a pair of lead terminals (201, 202) being embedded in said insulating base (300), and an outer end of each lead terminal (201, 202) extending outside from the said insulating base (300), said lead electrodes (103, 104) being electrically and mechanically bonded to said pair of lead terminals (201, 202) in said recess (301), a lid (500) made of thermoplastic resin being fitted in said recess (301), and the inside wall of the recess (301) and the outside wall of the lid (500) are fused together to form an airtight casing for the piezoelectric oscillator, characterized in that a first one (104) of said electrodes (103, 104) is bent about the periphery of the oscillating plate (100) to form a contact surface (106) on the same side of the oscillating plate (100) on which the contact surface (105) of the second electrode (103) is disposed and that the lead terminals (201, 202) pass through the insulating base (300) and having portions (205, 206) on the bottom of the recess (301) to which portions (205, 206) the contact surfaces (105, 106) are bonded.

2. The piezoelectric oscillator device according to claim 1 characterized in that intermediate portions of said lead terminals (201, 202) are embedded in said insulating base (300) when the same is molded to form said recess (301).

3. The piezoelectric oscillator device according to claim 1 or 2, characterized in that said pair of the lead terminals (201, 202) is arranged in parallel.

4. The piezoelectric oscillator device according to any one of claims 1—3 characterized in that each of said lead terminals (201, 202) is provided with notches (207—210) at points between said portions (205, 206) and said inside wall of said recess (301).

5. The piezoelectric oscillator device according to any one of claims 1—4 characterized in that said pair of the lead terminals (201, 202) is arranged on a line spaced from each other.

6. The piezoelectric oscillator device according to any one of claims 1—5 characterized in that each of said lead terminals (201, 202) is provided with two notches so as to form an S-shaped bridge portion (207A, 208A) at points between said portions at which they are bonded and said peripheral wall of said recess (301).

7. The piezoelectric oscillator device according to any one of claims 1—6 characterized in that a printed substrate (1200) mounting electrical circuit elements for exciting said piezoelectric oscillator is mounted in a bottom portion of said recess (1301), and inner ends (1127—1130) of said lead terminals (1101—1104) received in said recess (1301) are electrically connected to terminals of said printed substrate (1200).

8. The piezoelectric oscillator device according to claim 7 characterized in that said inner ends (1127—1130) of said lead terminals (1101—1104) are bent into L shapes.

9. The piezoelectric oscillator device according to any one of claims 1—8 characterized in that said piezoelectric oscillating plate (100) and said recess (301; 1301) are circular.

10. The piezoelectric oscillator device according to any one of claims 1—8 characterized in that said piezoelectric oscillating plate (100A) and said recess (301) are rectangular (Fig. 27, 28).

11. The piezoelectric oscillator device according to any one of claims 1—8 characterized in that said piezoelectric oscillating plate (100) and said recess (301) are square (Fig. 14—26).

12. The piezoelectric oscillator device according to either one of claims 1—11 characterized in that the recess (301) of the insulating base (300) comprises shoulders (302, 303) for receiving undersides of said lid (500).

13. A method of manufacturing a piezoelectric oscillator device of the type wherein exciting electrodes (101, 102) attached to the opposite surfaces of a piezoelectric oscillating plate (100) are electrically and mechanically bonded to lead terminals (201, 202) and the piezoelectric oscillating plate (100) is housed in a casing, whereby the piezoelectric oscillating plate (100) is further provided with lead electrodes (103, 104) extending from the exciting electrodes (101, 102) to the periphery of the piezoeletric oscillating plate (100), an insulating base (300) made of a thermoplastic resin being provided with a recess (301) adapted to receive said piezoelectric oscillating plate (100), a pair of lead terminals (201, 202) being embedded in said insulating base (300), and an outer end of each lead terminal (201, 202) extending outside from the said insulating base (300), said lead electrodes (103, 104) being electrically and mechanically bonded to said pair of lead terminals (201, 202) in said recess (301), a lid (500) made of thermoplastic resin being fitted in said recess (301), and the inside wall of the recess (301) and the outside wall of the lid (500) are fused together to form an airtight casing for the piezoelectric oscillator, characterized in that a first one (104) of said electrodes (103, 104) is being bent about the periphery of the oscillating plate (100) to form a contact surface (106) on the same side of the oscillating plate (100) on which the contact surface (105) of the second electrode (103) is disposed and that the contact surfaces (105, 106) are being bonded to portions (205, 206) of the lead terminals (201, 202) on the bottom of the recess (301), which lead terminals (201, 202) pass through the insulating base (300).

14. The method of manufacturing the piezoelectric oscillator device according to claim 13 characterized in that a printed substrate (1200) where electrical circuit elements for exciting said piezoelectric oscillator are mounted is bonded to inner ends (1127—1130) of said pair of lead terminals (1101—1104), and then said pair of lead terminals is molded to form said insulating base provided with the recess (1301).

## Patentansprüche

1. Piezoelektrische Oszillatorvorrichtung derjenigen Art, bei der Erregerelektroden (101, 102), die an den entgegengesetzten Oberflächen einer piezoelektrischen Schwingungsplatte (100) elektrisch und mechanisch an Leitungsanschlüsse (201, 202) gebunden sind und die piezoelektrische Schwingungsplatte (100) in einem Gehäuse aufgenommen ist, wobei die piezoelektrische Schwingungsplatte (100) ferner mit Leitungselektroden (103, 104) versehen ist, die sich von den Erregerelektroden (101, 102) zum Umfang der piezoelektrischen Schwingungsplatte (100) erstrecken, eine isolierende Basis (100) aus thermoplastischem Harz mit einer Ausnehmung (301) versehen ist, die dazu ausgebildet ist, die piezoelektrische Schwingungsplatte (100) aufzunehmen, wobei ferner ein Paar von Leitungsanschlüssen (201, 202) in der isolierenden Basis (300) eingebettet ist und ein äußeres Ende jedes Leitungsanschlusses (201, 202) sich außerhalb der isolierenden Basis (300) erstreckt, wobei die Leitungselektroden (103, 104) elektrisch und mechanisch mit dem Paar von Leitungsanschlüssen (201, 202) in der Ausnehmung (301) verbunden sind, ein Deckel (500) aus thermoplastischem Harz in die Ausnehmung (301) eingesetzt ist und die innere Wand der Ausnehmung (301) und die äußere Wand des Deckels (500) verschmolzen sind, um für den piezoelektrischen Oszillator ein luftdichtes Gehäuse zu bilden, dadurch gekennzeichnet, daß eine erste (104) der Elektroden (103, 104) um den Umfang der Schwingungsplatte (100) herum gebogen ist, so daß eine Kontaktfläche (106) an der gleichen Seite der Schwingungsplatte (100) gebildet wird, an der die Kontaktfläche (105) der zweiten Elektrode (103) angeordnet ist, und daß die Leitungsanschlüsse (201, 202) durch die isolierende Basis (300) hindurch verlaufen und Abschnitte (205, 206) auf dem Boden der Ausnehmung (301) aufweisen, wobei an diesen Abschnitten (205, 206) die Kontaktflächen (105, 106) haftend verbunden sind.

2. Oszillatorvorrichtung nach Anspruch 1, dadurch gekennzeichnet, daß die mittleren Teile der Leitungsanschlüsse (201, 202) in der isolierenden Basis (300) eingebettet werden, wenn diese zur Bildung der Ausnehmung (301) geformt wird.

3. Oszillatorvorrichtung nach Anspruch 1 oder 2, dadurch gekennzeichnet, daß das Paar der Leitungsanschlüsse (201, 202) parallel angeordnet ist.

4. Oszillatorvorrichtung nach einem der Ansprüche 1 bis 3, dadurch gekennzeichnet, daß jeder der Leitungsanschlüsse (201, 202) mit Kerben (207—210) an Punkten zwischen den Abschnitten (205, 206) und der inneren Wand der Ausnehmung (301) versehen ist.

5. Oszillatorvorrichtung nach einem der Ansprüche 1 bis 4, dadurch gekennzeichnet, daß das Paar der Leitungsanschlüsse (201, 202) auf einer Linie im Abstand zueinander angeordnet ist.

6. Oszillatorvorrichtung nach einem der Ansprüche 1 bis 5, dadurch gekennzeichnet, daß jeder der Leitungsanschlüsse (201, 202) mit zwei Kerben versehen ist, so daß ein S-förmiger Brückenteil (207A, 208A) an Punkten zwischen den Abschnitten, an denen sie haftend verbunden sind, und der Umfangswand der Ausnehmung (301) gebildet wird.

7. Oszillatorvorrichtung nach einem der Ansprüche 1 bis 6, dadurch gekennzeichnet, daß ein gedrucktes Substrat (1200) zur Montage elektrischer Schaltungselemente zur Erregung des piezoelektrischen Oszillators in einem Bodenteil der Ausnehmung (1301) angebracht ist, und daß innere Enden (1127—1130) der Leitungsanschlüsse (1101—1104), die in der Ausnehmung (1301) aufgenommen sind, elektrisch mit Anschlüssen des gedruckten Substrats (1200) verbunden sind.

8. Oszillatorvorrichtung nach Anspruch 7, dadurch gekennzeichnet, daß die inneren Enden (1127—1130) der Leitungsanschlüsse (1101—1104) in L-Gestalt gebogen sind.

9. Oszillatorvorrichtung nach einem der Ansprüche 1 bis 8, dadurch gekennzeichnet, daß die piezoelektrische Schwingungsplatte (100) und die Ausnehmung (301; 1301) kreisförmig sind.

10. Oszillatorvorrichtung nach einem der Ansprüche 1 bis 8, dadurch gekennzeichnet, daß die piezoelektrische Schwingungsplatte (100A) und die Ausnehmung (301) rechteckig sind (Fig. 27, 28).

11. Oszillatorvorrichtung nach einem der Ansprüche 1 bis 8, dadurch gekennzeichnet, daß die piezoelektrische Schwingungsplatte (100) und die Ausnehmung (301) quadratisch sind (Fig. 14—26).

12. Oszillatorvorrichtung nach einem der Ansprüche 1 bis 11, dadurch gekennzeichnet, daß die Ausnehmung (301) der isolierenden Basis (300) Schultern (302, 303) zur Aufnahme von Unterseiten des Deckels (500) aufweist.

13. Verfahren zur Herstellung einer piezoelektrischen Oszillatorvorrichtung derjenigen Art mit Erregerelektroden (101, 102), die an entgegengesetzten Oberflächen einer piezoelektrischen Schwingungsplatte (100) befestigt und elektrisch und mechanisch mit Leitungsanschlüssen (201, 202) verbunden sind, wobei die piezoelektrische Schwingungsplatte (100) in einem Gehäuse aufgenommen ist, und die piezoelektrische Schwingungsplatte (100) überdies mit Leitungselektroden (103, 104) versehen ist, die sich von den Erregerelektroden (101, 102) zur Umfang der piezoelektrischen Schwingungsplatte (100) erstrecken, ferner mit einer isolierenden Basis (300) aus thermoplastischem Harz, die mit einer Ausnehmung (301) versehen ist, welche zur Aufnahme der piezoelektrischen Schwingungsplatte (100) ausgebildet ist, wobei ein Paar von Leitungsanschlüssen (201, 202) in der isolierenden Basis (300) eingebettet ist und sich ein äußeres Ende jedes Leitungsanschlusses (201, 202) außerhalb der isolierenden Basis (300) erstreckt, wobei ferner die Leitungselektroden (103, 104) elektrisch und mechanisch mit dem Paar von Leitungsanschlüssen (201, 202) in der Ausnehmung (301) haftend verbunden sind, und ferner ein Deckel (500) aus thermoplastischem Harz in die Ausnehmung (301) eingepaßt ist, und wobei die innere Wand der Ausnehmung (301) und die äußere Wand des Deckels (500) miteinander verschmolzen sind, um ein luftdichtes Gehäuse für den piezoelektrischen Oszillator zu bilden, dadurch gekennzeichnet, daß eine ersten (104) der Elektroden (103, 104) um den Umfang der Schwingungsplatte (100) herum gebogen wird, um eine Kontaktoberfläche (106) auf der gleichen Seite der Schwingungsplatte (100) zu bilden, auf der die Kontaktfläche (105) der zweiten Elektrode (103) angeordnet ist, und daß die Kontaktflächen (105, 106) mit Abschnitten (205, 206) der Leitungsanschlüsse (201, 202) auf dem Boden der Ausnehmung (301) haftend verbunden werden, wobei diese Leitungsanschlüsse (201, 202) durch die isolierende Basis (300) hindurchgehen.

14. Verfahren nach Anspruch 13, dadurch gekennzeichnet, daß ein gedrucktes Substrat (1200), auf dem elektrische Schaltungselemente zur Erregung des piezoelektrischen Oszillators angebracht sind, mit inneren Enden (1127—1130) des Paars von Leitungsanschlüssen (1101—1104) leitend verbunden wird, und daß dann das Paar der Leitungsanschlüsse geformt wird, umd die mit der Ausnehmung (1301) versehene isolierende Basis zu bilden.

**Revendications**

1. Oscillateur piézoélectrique du type dans lequel des électrodes d'excitation (101, 102) attachées aux surfaces opposées d'une plaque d'oscillation piézoélectrique (100) sont liées électriquement et mécaniquement à des terminaux conducteurs (201, 202) et dans lequel la plaque d'oscillation piézoélectrique (100) est logée dans un boitier, cette plaque d'oscillation piézoélectrique (100) étant en outre munie d'électrodes conductrices (103, 104) s'étendant des électrodes d'excitation (101, 102) jusqu'à la périphérie de la plaque d'oscillation piézoélectrique (100), un support isolant (300) réalisé en résine thermoplastique étant doté d'un évidement (301) adapté pour recevoir la plaque d'oscillation piézoélectrique (100), une paire de terminaux conducteurs (201, 202) étant encastrés dans le support isolant, une extrémité extérieure de chacun de ces terminaux conducteurs (201, 202) s'étendant au dehors du support isolant (300), les électrodes conductrices (103, 104) étant liés électriquement et mécaniquement à la paire de terminaux conducteurs (201, 202) disposés dans l'évidement (301), un couvercle (500) réalisé en résine thermoplastique étant ajusté dans l'évidement (301), la paroi intérieure de l'évidement (301) et la paroi extérieure du couvercle (500) étant jointes l'une à l'autre de manière à former un boitier étanche à l'air pour l'oscillateur piézoélectrique, caractérisé en ce que la première (104) de ces électrodes (103, 104) est recourbée dans le sens de la périphérie de la plaque d'oscillation (100) pour former une surface de contact (106) du même côté de la plaque d'oscillation (100) sur lequel est disposée la surface de contact (105) de la deuxième électrode (103) et en ce que les terminaux conducteurs (201, 202) passent à travers le support isolant (300) et comportent des portions (205, 206) disposées sur le fond de l'évidement (301), portion auxquelles sont liées les surfaces de contact (105, 106).

2. Oscillateur piézoélectrique selon la revendication 1, caractérisé en ce que des portions intermédiaires des terminaux conducteurs (201, 202) sont encastrés dans le support isolant (300) lorsque celui-ci est moulé pour former l'évidement (301).

3. Oscillateur piézoélectrique selon la revendication 1 ou 2, caractérisé en ce que la paire de terminaux conducteurs (201, 202) est disposée en parallèle.

4. Oscillateur piézoélectrique selon l'une quelconque des revendications 1—3, caractérisé en ce que chacun des terminaux conducteurs (201, 202) est doté d'entailles (207—210) en des points situés entre les portions (205, 206) et la paroi intérieure de l'évidement (301).

5. Oscillateur piézoélectrique selon l'une quelconque des revendications 1—4, caractérisé en ce que la paire de terminaux conducteurs est disposée sur une ligne, les terminaux étant espacés l'un de l'autre.

6. Oscillateur piézoélectrique selon l'une quelconque des revendication 1—5, caractérisé en ce que chacun des terminaux conducteurs (201, 202) est doté de deux entailles formant une portion de pont en S (207A, 208A) en des points situés entre les portions en lesquelles ils sont liés, d'une part, et la paroi périphérique de l'évidement (301), d'autre part.

7. Oscillateur piézoélectrique selon l'une quelconque des revendications 1—6, caractérisé en ce que un substrat (1200) sur lequel sont imprimés des éléments de circuit destinés à exciter l'oscillateur piézoélectrique est monté dans un secteur postérieur de l'évidement (1301), et en ce que les extrémités intérieures (1127—1139) des terminaux conducteurs (1101—1104) aboutissant dans l'évidement en question (1301) sont raccordés électriquement au substrat imprimé (1200).

8. Oscillateur piézoélectrique selon la revendication 7, caractérisé en ce que les extrémités intérieures (1127—1130) des terminaux conducteurs (1101—1104) sont recourbées pour former un L.

9. Oscillateur piézoélectrique selon l'une quelconque des revendications 1—8, caractérisé en ce que la plaque d'oscillation piézoélectrique (100) et l'évidement (301; 1301) ont une forme circulaire.

10. Oscillateur piézoélectrique selon l'une quelconque des revendications 1—8, caractérisé en ce que la plaque d'oscillation piézoélectrique (100A) et l'évidement (301) sont rectangulaires (fig. 27, 28).

11. Oscillateur piézoélectrique selon l'une quelconque des revendications 1—8, caractérisé en ce que la plaque d'oscillation piézoélectrique (100) et l'évidement (301) sont carrés (fig. 14—26).

12. Oscillateur piézoélectrique selon l'une quelconque des revendications 1—11 caractérisé en ce que l'évidement (301) du support isolant (300) comporte des épaules (302, 303) destinées à recevoir le côté inférieur du couvercle (500).

13. Méthode de fabrication d'un oscillateur piézoélectrique du type dans lequel des électrodes d'excitation (101, 102) attachées aux surfaces opposées d'une plaque d'oscillation piézoélectrique (100) sont liées électriquement et mécaniquement à des terminaux conducteurs (201, 202) et dans lequel la plaque d'oscillation piézoélectrique (100) est logée dans un boitier, cette plaque d'oscillation piézoélectrique (100) étant en outre munie d'électrodes conductrices (103, 104) s'étendant des électrodes d'excitation (101, 102) jusqu'à la périphérie de la plaque d'oscillation piézoélectrique (100), un support isolant (300) réalisé en résine thermoplastique étant doté d'un évidement (301) adapté pour recevoir la plaque d'oscillation piézoélectrique (100), une paire de terminaux conducteurs (201, 202) étant encastrés dans le support isolant, une extrémité extérieure de chacun de ces terminaux (201, 202) s'étendant au dehors du support isolant (300), un couvercle (500) réalisé en résine thermoplastique étant ajusté dans l'évidement (301), la paroi intérieure de l'évidement (301) et la paroi extérieure du couvercle (500) étant jointes l'une à l'autre de manière à former un boitier étanche à l'air pour l'oscillateur piézoélectrique, caractérisée en ce que la première (104) de ces électrodes (103, 104) est recourbée dans le sens de la périphérie de la plaque d'oscillation (100) pour former une surface de contact (106) du même côté de la plaque d'oscillation (100) sur lequel est disposée la surface de contact (105) de la deuxième électrode (103) et en ce que les surfaces de contact (205, 206) sont liées à des portions (201, 202) des terminaux conducteurs (201, 202) sur le fond de l'évidement (301), ces terminaux conducteurs (201, 202) passant à travers le support isolé (300).

14. La méthode de fabrication de l'oscillateur piézoélectrique selon la revendication 13, caractérisée en ce que un substrat imprimé dans lequel sont montés des circuits électriques destinés à exciter l'oscillateur piézoélectrique est lié aux extrémités intérieures (1127—1130) de la paire de terminaux conducteurs (1101—1104), et qu'ensuite la paire de terminaux conducteurs est moulée pour former le support isolé dans lequel est pratiqué l'évidement (1301).

# FIG.1

# FIG.2

# FIG.3

# FIG.4

# FIG.5

# FIG.6

# FIG.7

# F I G.8

503
501
502
500
IX
IX

# F I G.9

500
503
501 502 501
503

# F I G.12

700
XIII
XIII

# F I G.13

700
700

# F I G.10

306,503
XI
XI
300
500

# F I G.11

205 100 206
300
304
500 501 306
503
600
600

# F I G.14

106
101
100
105
XV
XV
104 103

# F I G.15

104 102
105
106 101 103

# F I G.16

# F I G.17

# F I G.19

# F I G.18

# F I G.20

# F I G.21

# F I G.22

# FIG.23

306,503

XXIV  XXIV

300  500

# FIG.25

700

XXVI  XXVI

# FIG.24

205  100  206  300

305

500  501  306

503

600  600

# FIG.26

700  700

# FIG.27

306A  503A 104A 500A 101A 100  503A 306A

301

201A  300A  102A  103A  202A

# FIG.28

207A  104A  101A  103A  208A

XXVII  201A  100A  202A  XXVII

300A

# FIG.29

# FIG.30

# FIG.31

# FIG.32

# FIG.33

# FIG.34

# FIG.35

5

# FIG.36

XXXVII

1110
1106  1305  1107
1300  1121  1125  1307
XXXVIII        XXXVIII
1303  1308A
1301  1304
1302  1200
1113  1117
1101  1306  1102
1105
XXXVII

# FIG.37

1113  1200  1308A
1306  1303  1305
1308  1302  1121  1308
1307  1307
1105  1301  1110  1300

# FIG.38

1308  1121  1200  1304
1303  1305  1125  1308A
1307  1308
1307
1301

# FIG.39

Z'
X
Y'
1400

# FIG.40

XXXX
1402
1401  1404
1405
1403
1400
1401  1404
1403  1402
1405
XXXX

# FIG.41

1110
1305  1404
1400  1409  1406
1121  1125
1303  1304
1113  1117
1408  1407
1306  1405
1105

# FIG.42

XXXXIII
1502  1503
1501
1500
XXXXIII

# FIG.43

1501  1503
1502
1501
1503

6

# F I G.44

# F I G.45

# F I G.46

# F I G.47

# F I G.48